**Europäisches Patentamt**

**European Patent Office**

**Office européen des brevets**

(19)

(11) Numéro de publication: **0 180 501**
**B1**

# FASCICULE DE BREVET EUROPEEN

(12)

(45) Date de publication du fascicule du brevet:
**28.12.88**

(51) Int. Cl.⁴: **B 61 B 12/06**

(21) Numéro de dépôt: **85401959.3**

(22) Date de dépôt: **08.10.85**

(54) Dispositif de détection et de localisation d'un défaut d'une installation de transport à câble aérien.

(30) Priorité: **15.10.84 FR 8415867**

(43) Date de publication de la demande:
**07.05.86 Bulletin 86/19**

(45) Mention de la délivrance du brevet:
**28.12.88 Bulletin 88/52**

(84) Etats contractants désignés:
**AT CH DE GB IT LI SE**

(56) Documents cités:
**EP-A- 0 095 956**
**FR-A- 2 313 247**
**FR-A- 2 408 495**
**FR-A- 2 440 637**
**FR-A- 2 504 482**
**US-A- 4 088 988**

(73) Titulaire: **POMAGALSKI S.A., 11, rue René Camphin,
F-38600 Fontaine (FR)**

(72) Inventeur: **Bertrand, Jean-Jacques, 11, rue René
Camphin, F-38600 Fontaine (FR)**

(74) Mandataire: **Kern, Paul, 206, Cours de la Libération,
F-38100 Grenoble (FR)**

ACTORUM AG

## Description

L'invention est relative à un dispositif de détection de l'état électrique d'une ligne de sécurité s'étendant le long d'une installation de transport à câble aérien entre les deux stations d'extrémités et comprenant des contacts électriques échelonnés le long de la ligne, lesdits contacts étant connectés électriquement en série dans la ligne et commandés à l'ouverture par des détecteurs de défaut, notamment d'un déraillement du câble et analogues.

Un dispositif de détection du genre mentionné ou groupe de sécurité, a pour rôle essentiel la surveillance de la ligne de sécurité et la commande de l'arrêt de l'installation dès que la continuité de la ligne n'est plus établie. L'interruption de la ligne de sécurité peut résulter d'une ouverture d'un contact de fin de course ou de secours ou de l'action d'un détecteur d'un incident, par exemple du déraillement du câble des galets d'un pylône, qui provoque la rupture d'une barrette de sécurité ou un sectionnement de la ligne.

L'interruption est plus ou moins franche et les dispositifs conventionnels (tel que celui décrit dans le FR-A-2 440 637) mesurent la résistance apparente de la ligne, qui comprend deux paramètres:

la résistance série RL, constituée par la résistance du câble et la somme des résistances des contacts inserés dans la ligne et la résistance parallèle RP, due à des fuites résistives ou capacitives, par exemple au niveau des pylônes. La mesure de la résistance apparente ne constitue pas une méthode fiable, un incident provoquant une augmentation de la résistance série par ouverture d'un contact pouvant fort bien être masqué par une diminution concomitante de la résistance parallèle, la combinaison de ces effets se traduisant par une résistance apparente correcte.

La présente invention a pour but de réaliser un dispositif fiable qui détecte sans ambiguïté une anomalie de la ligne de sécurité.

Le dispositif de détection selon l'invention est caractérisé en ce qu'il comporte:

– un générateur d'un courant ou d'un signal alternatif carré disposé dans l'une des stations et connecté d'une part à l'extrémité de la ligne de sécurité et d'autre part à un circuit de retour constitué par la terre ou un conducteur de retour qui forme avec la ligne de sécurité un circuit en boucle reliant les deux stations.

– un dispositif redresseur, tel qu'une diode, disposé dans la station opposée à celle du générateur et inséré dans ledit circuit en boucle.

– et un dispositif de mesure, disposé dans la station du générateur pour mesurer les alternances positives et négatives dudit signal et fournir un signal représentatif de l'état de la ligne.

Lorsque la polarité du signal, appliqué à la ligne, correspond au sens passant de la diode on mesure la résistance apparente de la ligne de la manière usuelle. Pendant l'alternance suivante de polarité opposée la diode bloquée interrompt la ligne et la mesure correspond sensiblement à la résistance parallèle RP.

En effectuant ces deux mesures, l'une correspondant à la ligne fermée et l'autre à la ligne ouverte, il est possible de déterminer l'état électrique de la ligne. En admettant que le signal + corresponde au sens passant de la diode, on peut dire en première approximation que la présence du signal pendant l'alternance + et l'absence pendant l'alternance – traduisent une continuité de la ligne.

L'absence du signal + et du signal – correspond à une interruption de la ligne et la présence du signal – et du signal + correspond à un court-circuit de la ligne, notamment une mise à la terre de la ligne.

La présence permanente de résistances parasites en série et en parallèle de la ligne affecte les mesures, qui sont moins franches et selon un développement de l'invention l'arrêt de l'installation est provoquée lorsque les mesures ne sont pas comprises dans des fourchettes prédéterminées, facilement calculables.

En fonctionnement normal la tension sur la ligne ne peut être inférieure à une tension de diode, ni plus négative que le signal négatif généré et le dispositif de mesure détecte ces anomalies.

Le circuit électronique de mesure comprend un sélecteur à deux circuits, l'un pour émettre le signal alternatif sur la ligne et l'autre pour recueillir par des capacités de filtrage les tensions positives + VL et négatives – VL sur la ligne.

Les tensions + VL et – VL sont appliquées chacune à un circuit comparateur fonctionnant en mode dynamique, qui provoque l'arrêt de l'installation dès la disparition d'une seule transition sur l'un des comparateurs.

Il y a un double contrôle en fréquence (présence de chaque impulsion) et en amplitude (mesure de Rp et RL).

Le dispositif de détection est avantageusement combiné à un localisateur de l'incident, basé sur la réflexion d'onde par la discontinuité ou le court-circuit de la ligne.

A cet effet, il est fait usage du front montant du signal émis sur la ligne par le dispositif détecteur, dont la variation est représentative de la nature de l'incident et de la durée de parcours de l'onde sur la ligne, c'est-à-dire de la distance du défaut.

Un système d'affichage complète les dispositifs de détection et de localisation.

La mesure est effectuée par scrutation et comparaison avec un état mémorisé de la ligne réputée bonne. Cet état mémorisé étalon peut à tout instant être réactualisé automatiquement pour tenir compte des variations lentes des valeurs caractéristiques de la ligne et éviter ainsi des indications intempestives de défauts.

D'autres avantages et caractéristiques de l'invention ressortiront plus clairement de la description qui va suivre, d'un mode de mise en œuvre de l'invention, donné à titre d'exemple non limitatif et représenté aux dessins annexés, dans lesquels:

– la figure 1 est une vue schématique en perspective d'un télésiège équipé d'un dispositif de détection selon l'invention;

— la figure 2 montre le schéma électrique équivalent de la ligne de sécurité;

— la figure 3 illustre le fonctionnement des sélecteurs;

— la figure 4 est un schéma bloc du circuit de mesure;

— la figure 5 est une vue schématique de la ligne de sécurité;

— la figure 6 montre la courbe de variation du front du signal analysé par le localisateur.

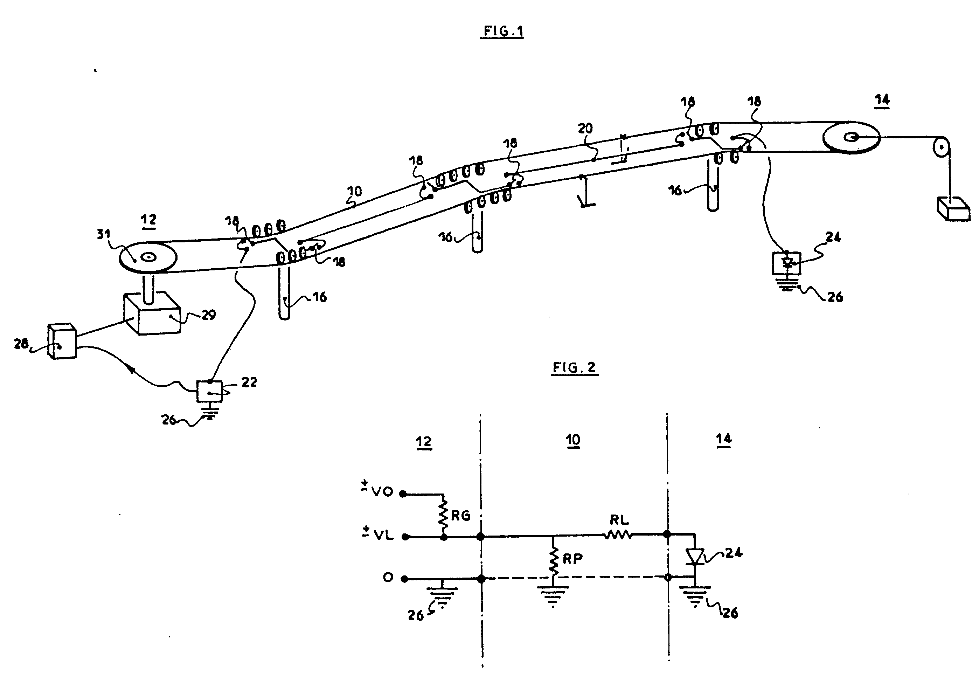

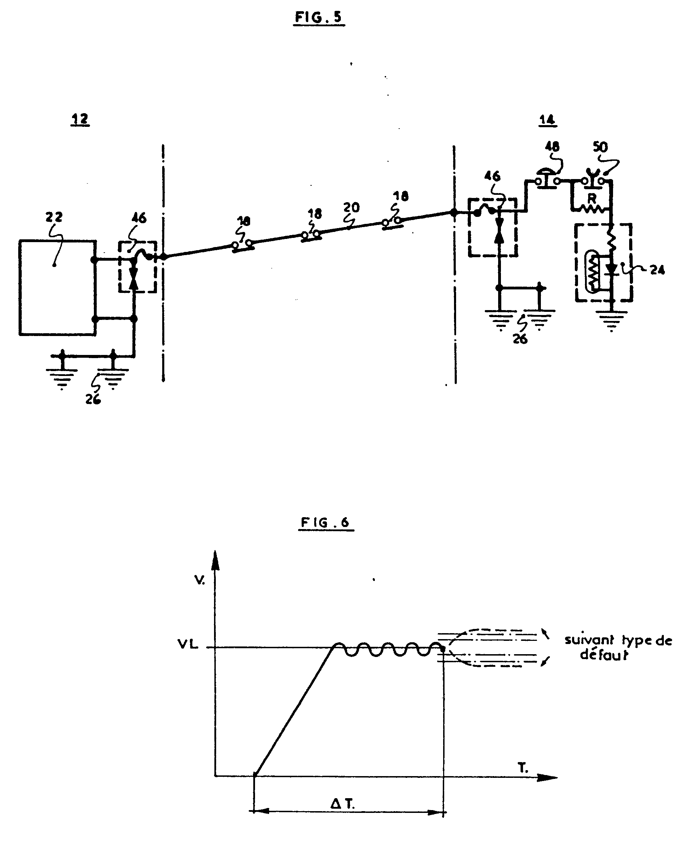

Sur les figures 1 et 5, le câble 10 d'un télésiège s'étend entre une station motrice 12 et une station 14 de tension en étant porté par des pylônes 16. L'invention est décrite appliquée à un télésiège, mais il est clair qu'elle est applicable à tout transporteur à câble, notamment à un téléski, à une télécabine, un téléphérique et analogue. Les pylônes 16 portent des détecteurs de l'intégrité des supports du câble en particulier des détecteurs de déraillement du câble qui ouvrent des contacts électriques 18 lors d'une chute du câble.

Ces contacts 18 sont connectés en séries dans une ligne de sécurité 20 constituée par exemple, par un câble électrique qui s'étend entre les station 12, 14.

La ligne de sécurité 20 est raccordée dans la station motrice 12 à un coffret ou groupe 22 et dans la station opposée par l'intermédiaire d'un élément redresseur, par exemple und diode 24 à la terre 26.

Le groupe 22 est également connecté à la terre 26 qui constitue le conducteur de retour de la ligne, lequel peut être réalisé par un deuxième câble reliant les deux stations 12, 14. Le groupe 22 est relié au bloc d'alimentation 28 du moteur 29 d'entraînement de la poulie 31 du câble 10 pour commander l'arrêt de l'installation lors d'une interruption de la ligne de sécurité.

Une telle installation à câble aérien est bien connue des spécialistes et il est inutile de la décrire plus en détail.

Selon la présente invention un générateur 30 du groupe 22 émet sur la ligne de sécurité 20 un signal alternatif, par exemple un signal carré alternatif de tension + Vo et − Vo. La ligne 20 se comporte comme un circuit électrique ayant une résistance série RL et une résistance parallèle RP, la résistance série RL résultant des résistances des éléments constitutifs de la ligne 20 connectés en série, notamment des contacts 18 et du câble de la ligne.

La résistance parallèle RP est due aux résistances de fuite vers la terre 26. Sur la figure 2 on voit que pour un signal positif + Vo la diode 24 est conductrice et que la quasi totalité du courant passe par la résistance série RL, dont la valeur est beaucoup plus faible que celle de la résistance parallèle RP.

La tension + VL, présente aux bornes de la ligne 20, est essentiellement fonction de la résistance série RL.

Lors de l'alternance suivante du signal de tension − Vo, la diode 24 est bloquée et le courant passe uniquement par la résistance parallèle RP, la tension mesurée − VL étant représentative de cette résistance parallèle. L'ouverture d'un contact 18 est sans effet notable sur la tension − VL, le courant dans la ligne 20 étant déjà bloqué par la diode 24.

Par contre pour la polarité positive l'ouverture d'un contact 18 correspond à une augmentation de la résistance série RL, théoriquement à l'infini, et une augmentation correspondante de la tension + VL.

L'emploi d'un signal alternatif et d'une diode disposée dans la station opposée permet ainsi par la surveillance de la tension de la ligne 20 de déterminer sélectivement la résistance série RL et la résistance parallèle RP.

Sur la figure 2 la résistance interne du générateur 30 du groupe de sécurité 22 porte le repère RG.

Le générateur 30 est piloté par une horloge 32 pour emettre un signal carré + Vo, − Vo alternatif appliqué à la ligne de sécurité 20.

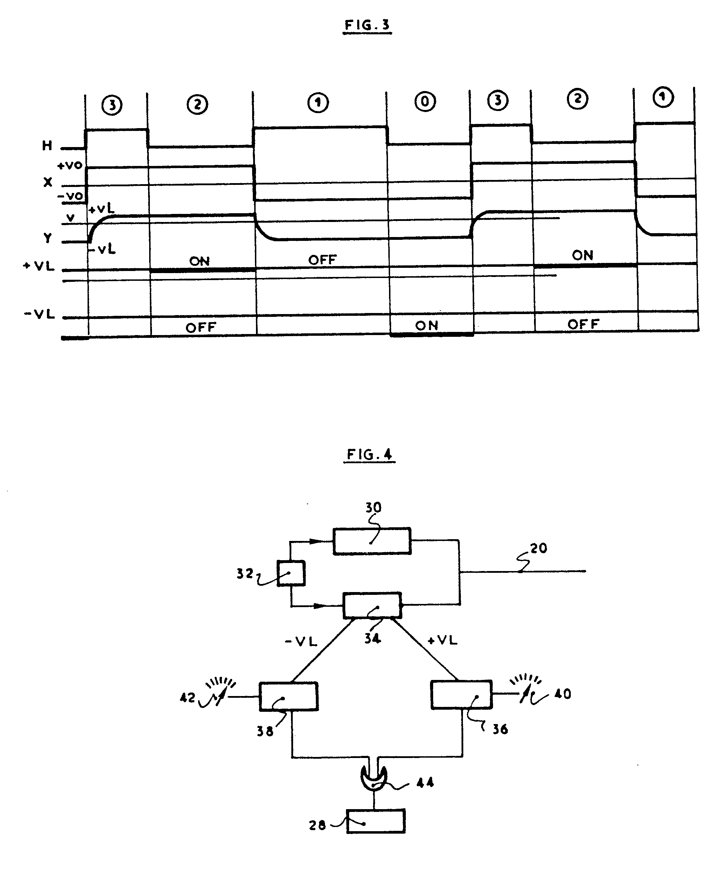

Le signal est représenté par la courbe X sur la figure 3, l'horloge correspondant à la courbe H. Les signaux + VL et − VL recueillis aux bornes de la ligne 20 par un circuit de mesure 34 sont représentés en Y. Le circuit de mesure 34 comprend un sélecteur piloté par l'horloge 32 qui selectionne les signaux + VL et − VL pour s'affranchir des transitoires. Chaque signal + VL, − VL est transmis à une chaîne de comparaison 36, 38 ayant un affichage 40, 42 des valeurs de seuil SL, SP auxquelles sont comparés les signaux + VL, − VL.

La chaîne 36 émet un signal d'arrêt du télésiège lorsque VL dépasse le seuil SL tandis que la chaîne 38 émet un signal d'arrêt lorsque le signal VL est inférieur au seuil SP. Les valeurs de SL et SP dépendent des caractéristiques de l'installation et elles peuvent être déterminées par le calcul en connaissance des paramètres, notamment des résistances RL, RP et RG ou expérimentalement.

Chaque chaîne 36, 38 peut comporter un deuxième affichage pour définir une fourchette dans laquelle le signal + VL ou − VL doit être compris.

Les signaux d'arrêt émis par les chaînes 36, 38 sont appliqués à une porte OU 44 qui transmet le signal au bloc 28 d'alimentation du moteur. Le groupe de sécurité comporte bien entendu un affichage du signal ayant provoqué l'arrêt de l'installation.

La figure 5 montre une ligne de sécurité 20 selon l'invention équipée de parafoudres 46 dans chacune des stations 12, 14. La station 14 équipée du bloc redresseur 24 comporte un interrupteur 48 à bouton poussoir pour un arrêt d'urgence et un interrupteur 50 commandé par le portillon de sécurité.

Les deux interrupteurs 48, 50 sont connectés en série dans la ligne de sécurité 20 pour provoquer l'arrêt de l'installation lors de leur ouverture de la manière décrite ci-dessus pour les contacts 18.

Une résistance R est montée en parallèle de l'interrupteur 50, le courant étant dérivé par cette résistance R shunt lors de l'ouverture de l'interrupteur.

La valeur de cette résistance étant connue et bien entendu différente de celle introduite lors de l'ouverture d'un contact 18 de pylône, la valeur du signal + VL permet une distinction de l'ouverture de cet interrupteur 50 de celle des contacts 18.

Le dispositif de détection décrit ci-dessus est, selon un perfectionnement combiné à un localisateur de l'incident faisant usage de la réflexion d'une onde sur une ligne ouverte ou court-circuitée.

La distance du défaut est déterminée à partir de la mesure du temps nécessaire à l'onde pour parcourir la distance aller et retour entre l'extrémité de mesure et le défaut. Selon l'invention on analyse le front montant du signal émis sur la ligne de sécurité 20 par le groupe 22.

L'oscillogramme de la figure 6 montre une variation brusque du signal + VL à l'emplacement du défaut, le signal augmentant lors d'une ouverture de la ligne et descendant lors d'un court-circuit de la ligne.

Le temps $\triangle t$ entre le début du signal et le point de changement brusque est proportionnel à la distance, ce qui permet une localisation du défaut. Cette distance est visualisée, par exemple par indication du pylône concerné.

Le signal émis par le groupe de sécurité peut bien entendu être d'une forme quelconque, à condition de présenter des fronts impulsionnels.

Sa fréquence est de préférence notablement supérieure à celle du réseau électrique mais on ne sortirait pas du cadre de l'invention en réalisant des mesures espacées. Le générateur et le dispositif de mesure peuvent être d'un type quelconque.

La précision de la détection est considérablement améliorée par le fait que la courbe de réponse étalon peut à tout moment être corrigée en fonction de l'évolution de la ligne (dans les conditions limites validées), d'où une détection à zéro flottant.

## Revendications

1. Dispositif de détection de l'état électrique d'une ligne (20) de sécurité s'étendant le long d'une installation de transport à câble aérien (10) entre les deux stations (12, 14) d'extrémités et comprenant des contacts électriques (18, 48, 50) échelonnés le long de la ligne (20) lesdits contacts étant connectés électriquement en série dans la ligne et commandés à l'ouverture par des détecteurs de défaut, notamment d'un déraillement du câble et analogues caractérisé en ce qu'il comporte:

– un générateur (30) d'un courant ou d'un signal alternatif disposé dans l'une des stations (12) et connecté d'une part à l'extrémité de la ligne (20) de sécurité et d'autre part à un circuit de retour constitué par la terre (26) ou un conducteur de retour qui forme avec la ligne (20) de sécurité un circuit en boucle reliant les deux stations (12, 14),

– un dispositif redresseur, tel qu'une diode (24), disposé dans la station opposée (14) à celle du générateur (30) et inséré dans ledit circuit en boucle,

– et un dispositif de mesure (34), disposé dans la station (12) du générateur (30) pour mesurer les alternances (+ VL, – VL) positive et négative dudit signal et fournir un signal représentatif de l'état de la ligne.

2. Dispositif de détection selon la revendication 1, caractérisé en ce que le dispositif de mesure (34) mesure les tensions (+ VL, – VL) aux bornes de la ligne (20) de sécurité respectivement pour l'alternance du courant, correspondant au sens passant du redresseur (24), cette tension + VL étant essentiellement représentative de la résistance série RL de la ligne et pour l'alternance opposée la tension – VL correspondante étant essentiellement représentative de la résistance parallèle RP de fuite de la ligne.

3. Dispositif de détection selon la revendication 2, caractérisé en ce que le dispositif de mesure (34) élabore un signal de défaut et (ou) d'arrêt de l'installation lorsque la tension + VL est supérieure à un seuil prédéterminé SL ou lorsque la tension – VL est inférieure à un seuil prédéterminé SP.

4. Dispositif de détection selon la revendication 3, caractérisée en ce qu'un signal d'alarme et (ou) d'arrêt est émis lorsque la résistance série RL est supérieure à 1500 ohms et ou lorsque la résistance parallèle RP est inférieure à 3200 ohms, par comparaison aux seuils prédéterminés (40, 42).

5. Dispositif de détection selon la revendication 1, 2, 3 ou 4 caractérisé en ce qu'un contact 50 d'arrêt est inséré à l'extrémité de la ligne (20) dans ladite station opposée (14), ledit contact étant shunté par une résistance (R) d'une valeur inférieure à la résistance minimale d'un contact (18) en ligne.

6. Dispositif de détection selon la revendication 4, caractérisé en ce que le signal d'alarme et (ou) d'arrêt est émis lorsque la résistance série (RL) est inférieure à celle du dispositif redresseur.

7. Dispositif de détection et de localisation selon l'une des revendications précédentes, caractérisé en ce que le dispositif de mesure (34) analyse le front montant du signal émis sur la ligne (20) et détermine une variation importante révélatrice d'un incident, ainsi que la durée écoulée entre l'émission du signal et la détection de ladite variation pour localiser l'incident.

8. Dispositif de détection selon l'une des revendications précédentes, caractérisé en ce que ledit générateur (30) émet un signal carré alternatif d'une fréquence nettement supérieure à celle du réseau électrique.

9. Dispositif de localisation selon l'une des revendications précédentes, caractérisé en ce que le dispositif de mesure (34) comporte un système de scrutation pour déterminer la valeur du signal et la comparer à la valeur mémorisée précédente de ce signal, prise comme valeur de référence pour la comparaison à des seuils prédéterminés fixant la sensibilité donc la précision de la localisation.

**Patentansprüche**

1. Detektiervorrichtung des elektrischen Zustandes einer Sicherheitsleitung (20), die sich längs einer Transportinstallation mit Luftseil (10) zwischen zwei Endstationen (12, 14) erstreckt, mit längs der Bahn (20) gestaffelten elektrischen Kontakten (18, 48, 50), wobei die genannten Kontakte elektrisch in Serie in der Leitung geschaltet sind und durch Detektoren eines Fehlers, insbesondere einer Seilentgleisung oder ähnliches, geöffnet werden, dadurch gekennzeichnet, dass sie aufweist:

- einen Generator (30) eines Wechselstromes oder rechteckigen Signals, der in einer der Stationen (12) aufgestellt ist und einerseits an dem Ende der Sicherheitsleitung (20) und andererseits an einem durch die Erde (26) oder einen Zurückleiter gebildeten Zurückstromkreis verbunden ist, welcher mit der Sicherheitsleitung (20) einen die beiden Stationen (12, 14) verbindenden Schleifenstromkreis bildet,

- eine Gleichrichtervorrichtung wie eine Diode (24), die in der dem Generator (30) gegenüberliegenden Station (14) aufgestellt ist, und die in dem genannten Schleifenstromkreis geschaltet ist,

- und eine in der Station (12) des Generators (30) aufgestellte Messvorrichtung (34), um die positiven und die negativen Alternanzen (+ VL, − VL) des genannten Signals zu messen und ein den Zustand der Leitung anzeigendes Signal zu liefern.

2. Detektiervorrichtung nach Anspruch 1, dadurch gekennzeichnet, dass die Messvorrichtung (34) die Spannungen (+ VL, − VL) an den Klemmen der Sicherheitsleitung (20) misst, bzw. für die dem Leiten des Gleichrichters (24) entsprechende Stromalternanz, wobei diese Spannung (+ VL) hauptsächlich den Serienwiderstand (RL) der Leitung darstellt, und für die andere Stromalternanz, wobei die entsprechende Spannung (− VL) hauptsächlich den Reihenwiderstand (RP) der Leitungslecke darstellt.

3. Detektiervorrichtung nach Anspruch 2, dadurch gekennzeichnet, dass die Messvorrichtung (34) ein Fehlersignal und (oder) Anlegestopsignal ausarbeitet, wenn die Spannung (+ VL) grösser als eine bestimmte Schwelle (SL) oder die Spannung (− VL) kleiner als eine bestimmte Schwelle (SP) ist.

4. Detektiervorrichtung nach Anspruch 3, dadurch gekennzeichnet, dass ein Alarmsignal und (oder) Stopsignal gesendet wird, wenn der Serienwiderstand (RL) grösser als 1500 Ohm ist, und, oder wenn der Reihenwiderstand (RP) kleiner als 3200 Ohm im Vergleich der vorbestimmten Schwellen (40, 42) ist.

5. Detektiervorrichtung nach Anspruch 1, 2, 3 oder 4, dadurch gekennzeichnet, dass ein Stopkontakt (50) am Ende der Leitung (20) in der genannten gegenüberliegenden Station (14) geschaltet ist, wobei dieser Kontakt durch einen Widerstand (R) von kleinerem Widerstand als der kleinste Bahnkontaktwiderstand (18) shuntiert ist.

6. Detektiervorrichtung nach Anspruch 4, dadurch gekennzeichnet, dass das Alarmsignal und (oder) Stopsignal gesendet wird, wenn der Serienwiderstand (RL) kleiner als der des Gleichrichters ist.

7. Detektiervorrichtung und Festlegungsvorrichtung nach einem der vorigen Ansprüche, dadurch gekennzeichnet, dass die Messvorrichtung (34) das auf der Bahn (20) gesendete steigende Frontsignal untersucht und eine wichtige einen Vorfall anzeigende Änderung bestimmt, sowie die Zeitdauer zwischen dem Aussenden des Signals und das Detektieren der genannten Änderung um den Vorfall festzulegen.

8. Detektiervorrichtung nach einem der vorigen Ansprüche, dadurch gekennzeichnet, dass der genannte Generator (30) ein viereckiges Wechselsignal von einer bedeutend grösseren Frequenz als die des Netzes aussendet.

9. Festlegungsvorrichtung nach einem der vorigen Ansprüche, dadurch gekennzeichnet, dass die Messvorrichtung (34) ein Untersuchsystem aufweist zum Bestimmen des Wertes des Signals und Vergleichen mit einem vorher gespeicherten Wert dieses Signals, der als Referenzwert zum Vergleich mit vorbestimmten, die Empfindlichkeit und die Festlegungsgenauigkeit bestimmenden Schwellen genommen wird.

**Claims**

1. Detection device of the electrical condition of a safety line (20) extending along the whole length of an aerial ropeway transport installation (10) between the two terminal stations (12, 14) and comprising electrical contacts (18, 48, 50) located at intervals along the line (20), said contacts being electrically connected in series in the line and controlled on opening by fault detectors, notably of a rope derailment, characterized in that:

- a current or AC signal generator (30) located in one of the stations (12) and connected on the one hand to the end of the safety line (20) and on the other hand to a return circuit constituted by the earth (26) or a return conductor which forms with the safety line (20) a loop circuit joining the two stations (12, 14),

- a rectifier device, such as a diode (24), located in the opposite station (14) from that of the generator (30) and inserted in said loop circuit,

- and a measuring device (34), located in the same station (12) as the generator (30), to measure the positive and negative alternations (+ VL, − VL) of said signal and to supply a signal representative of the line condition.

2. Detection device according to claim 1, characterized in that the measuring device (34) measures the voltages (+ VL, − VL) at the terminals of the safety line (20) respectively for the current alternation, corresponding to the flowing direction of the rectifier (24), this voltage + VL being essentially representative of the serial resistance RL of the line and for the opposite alternation the corresponding voltage − VL bein essentially representative of the parallel leakage resistance RP of the line.

3. Detection device according to claim 2, characterized in that the measuring device (34) generates a fault and (or) installation shutdown signal when the voltage + VL is greater than a preset threshold SL or when the voltage − VL is lower than a preset threshold SP.

4. Detection device according to claim 3, characterized in that an alarm and (or) shutdown signal is emitted when the serial resistance RL is greater than 1500 ohms and/or when the parallel resistance RP is lower than 3200 ohms, in comparison with the preset thresholds (40, 42).

5. Detection device according to claim 1, 2, 3 or 4, characterized in that a shutdown contact (50) is inserted at the end of the line (20) in said opposite station (14), said contact being shunted by a resistor (R) of a lower value than the minimum resistance of a line contact (18).

6. Detection device according to claim 4, characterized in that the alarm and (or) shutdown signal is emitted when the serial resistance (RL) is lower than that of the rectifier device.

7. Detection and localization device according to one of the preceding claims, characterized in that the measuring device (34) analyzes the rising front of the signal emitted on the line (20) and determines a large variation revealing that an incident has occurred, as well as the time between the signal being emitted and detection of said variation to localize the incident.

8. Detection device according to one of the preceding claims, characterized in that said generator (30) emits a square AC signal of a considerably higher frequency than that of the electrical mains.

9. Localization device according to one of the preceding claims, characterized in that the measuring device (34) comprises a scanning system to determine the value of the signal and to compare it with the previous stored value of this signal, taken as reference value for comparison with preset thresholds fixing the sensitivity, and therefore the accuracy of localization.

FIG. 1

FIG. 2

FIG. 3

FIG. 4

**FIG. 5**

**FIG. 6**

suivant type de
défaut